# DEMANDE DE BREVET EUROPEEN

(11) **EP 3 882 984 A1**
(43) Date de publication de la demande: **22.09.2021**
(21) Numéro de dépôt: 21163015.7
(22) Date de dépôt: 16.03.2021
(51) Int. Cl.: H01L 31/044

(54) **MODULE SOLAIRE AMELIORE**

(30) Priorité: 17.03.2020 FR 2002583
(71) Demandeur: Voltec Solar, 67190 Dinsheim-sur-Bruche (FR)
(72) Inventeur: WEISS, Lucas, 67480 Roppenheim (FR)
(74) Mandataire: Hege, Frédéric

(57) **Abrégé**

Module solaire, notamment de type photovoltaïque, comprenant des chaines (1), chaque chaine (1) comportant une ou plusieurs cellules (2) reliées électriquement en série, la surface totale couverte par les cellules (2) étant supérieure à 1,2 m², caractérisé en ce que :
- il comprend au moins un ensemble aller d'au moins trois chaines (1) reliées électriquement en parallèle entre elles, lesdits au moins un ensemble aller étant reliés électriquement en série entre eux et disposés entre une première borne (3) sur un premier côté (5a) dudit module et une deuxième borne située sur un deuxième côté (5b) opposé au premier côté (5a) dudit module,
- ledit module comportant une diode de dérivation (6) connectée électriquement en parallèle avec la totalité des cellules (2) dudit module.

## Description

La présente invention se situe dans le domaine de la production d'énergie. Elle concerne un module solaire, notamment de type photovoltaïque.

Les modules photovoltaïques sont généralement composés de cellules de base. Les modules comportent couramment 60 cellules, agencées en six rangées de 10 cellules. Les cellules de base sont de forme carrée. Il existe plusieurs dimensions de cellules de base standardisées, avec un côté pouvant mesurer entre 125 et 210 mm. Il est possible de couper les cellules de base pour modifier les caractéristiques de courant et de tension des modules. Dans le cas de cellules de base coupées en deux, les panneaux comportent généralement 120 cellules par exemple de dimension 156 x 78 mm.

Les cellules d'un module peuvent être arrangées selon différentes configurations. Dans les modules les plus simples, elles forment une chaine unique de cellules en série. Il existe également des modules comportant plusieurs chaines de cellules en parallèle. Ceci permet de réduire les pertes par effet Joule en diminuant le niveau de courant circulant dans les connecteurs entre les cellules. Ceci peut aussi permettre de lutter contre les problèmes d'ombrage. En effet lorsque les cellules d'un module sont toutes agencées en série, le courant du module correspond au courant de la cellule par laquelle passe le courant le plus faible. Il suffit donc qu'une seule cellule soit ombragée pour que la performance du module tout entier soit affectée. L'usage de chaînes agencées en parallèle permet de partager le courant du module dans plusieurs chaines afin de limiter ce problème. Toutefois si par exemple le module comporte deux chaines, et si le courant d'une des chaines est annulé à cause d'une de ses cellules, le courant total du module sera divisé par deux. Pour résoudre ce problème, certains modules comportent des diodes de dérivation, qui permettent de court-circuiter une chaine, et ainsi de préserver le courant total du module. Un système intelligent d'optimisation des performances du module permet de décider en temps réel l'activation ou non d'une diode de dérivation.

Le secteur de l'énergie solaire étant en plein développement, il existe différentes solutions combinant des demi-cellules et des arrangements particuliers de demi-cellules dans des modules, dans le but d'optimiser les performances des modules.

Plusieurs types de modules existent, les plus courants ayant une surface supérieure ou égale à 1,1 m². Le document FR1871040, par exemple, propose un module photovoltaïque comportant trois chaines aller de cellules disposées entre une borne d'entrée sur une première extrémité dudit module et une borne intermédiaire à l'autre extrémité dudit module, lesdites chaines aller étant reliées électriquement en parallèle entre elles. Le module comporte aussi trois chaines retour disposées entre ladite borne intermédiaire et une borne de sortie sur la première extrémité dudit module, lesdites chaines retour étant reliées électriquement en parallèle entre elles. Cependant ce module est cher à produire, et il existe un besoin de réduire les coûts.

Un objet de la présente invention est de proposer un module solaire permettant de produire de l'électricité de façon plus performante, plus simple et moins coûteuse.

Un autre objet de la présente invention est de proposer un module solaire à l'efficacité surfacique améliorée.

Un autre objet de la présente invention est de proposer un module solaire dont l'intégration dans une centrale solaire permet d'obtenir une centrale solaire simplifiée et moins coûteuse.

La présente invention a pour objet de répondre au moins en partie aux objets précités en proposant un module solaire à diode de dérivation unique. A cet effet, elle propose un module solaire, notamment de type photovoltaïque, comprenant des chaines, chaque chaine comportant une ou plusieurs cellules reliées électriquement en série, la surface totale couverte par les cellules étant supérieure à 1,2 m², caractérisé en ce que :
- il comprend au moins un ensemble aller d'au moins trois chaines reliées électriquement en parallèle entre elles, lesdits au moins un ensemble aller étant reliés électriquement en série entre eux et disposés entre une première borne sur un premier côté dudit module et une deuxième borne située sur un deuxième côté opposé au premier côté dudit module,
- ledit module comportant une diode de dérivation connectée électriquement en parallèle avec la totalité des cellules dudit module.

Grâce à ces dispositions, le module selon l'invention a des coûts de fabrication moins importants grâce au fait qu'il ne comporte qu'une diode de dérivation unique. De plus, selon le placement des boîtes de jonction, il est possible de diminuer la longueur de câbles nécessaire pour interconnecter plusieurs modules en série, ce qui diminue les coûts d'interconnexion des modules. Le module selon l'invention offre une sensibilité réduite aux ombrages et des meilleures performances de production d'électricité. Enfin Ce module peut également permettre d'économiser des câbles et de simplifier la centrale solaire dans lequel il est intégré, grâce à sa tension plus faible pour une même puissance électrique, qui permet un branchement en série d'un plus grand nombre de modules.

Selon d'autres caractéristiques :
- ladite diode de dérivation peut être connectée électriquement directement entre la première borne (3a) et la deuxième borne (3b), ce qui est un mode de réalisation simple et peu coûteux de l'invention,
- ledit module peut comprendre au moins un ensemble retour d'au moins trois chaines reliées électriquement en parallèle entre elles, lesdits au moins un ensemble retour étant reliés électriquement en série entre eux et disposés entre ladite deuxième borne et une troisième borne située sur le premier côté du module, ladite diode de dérivation étant connectée électriquement directement entre la première borne et ladite troisième borne, ce qui permet dans ce cas de ne pas nécessiter de ruban de cuivre reliant un côté à l'autre du module, ce qui augmente son efficacité surfacique et simplifie son procédé de fabrication,
- ledit module solaire peut comporter deux ensembles aller et deux ensembles retour, ce qui permet de réduire encore sa sensibilité aux ombrages,
- les cellules peuvent avoir une tension de claquage supérieure ou égale à 25V, ce qui permet de réduire les risques de détérioration du module en cas d'ombrage d'une des cellules,
- lesdites cellules peuvent comporter du silicium cristallin, technologie la plus répandue offrant les meilleurs performances pour un coût satisfaisant,
- la technologie de fabrication desdites cellules peut être une technologie comprise dans l'ensemble formé par la technologie PERC de type P (P-type Passivated Emitter Rear Contact), la technologie PERT de type N (N-type Passivated Emitter Rear Totally Diffused), la technologie TOPCon (Tunnel Oxide Passivated Contact), et la technologie à hétérojonction HJT (Heterojunction), ce qui est un mode de réalisation simple et peu cher de l'invention,
- la longueur desdites cellules (2) peut être égale à deux fois la largeur desdites cellules (2), ledit module pouvant comporter au moins 108 cellules (2), de préférence 120 cellules (2), ce qui permet d'optimiser encore la production d'énergie et d'obtenir un module facilement intégrable dans une centrale solaire existante, le nombre de cellules correspondant à une taille de module standard pour des demi-cellules de base, ledit module étant donc moins cher à fabriquer et plus facile à intégrer dans une centrale,
- la longueur desdites cellules (2) peut égale à six fois la largeur desdites cellules (2), ledit module pouvant comporter au moins 342 cellules (2), de préférence 380 cellules (2), ce qui permet d'optimiser encore la production d'énergie et d'obtenir un module facilement intégrable dans une centrale solaire existante, le nombre de cellules correspondant à une taille de module standard, ledit module étant donc moins cher à fabriquer et plus facile à intégrer dans une centrale,
- ledit module solaire peut être biverre, lesdites cellules (2) étant de préférence bifaciales, ce qui lui confère une meilleure tenue mécanique, le bifacial permettant d'augmenter les capacités de captation d'énergie du module.

La présente invention sera mieux comprise à la lecture de la description détaillée qui fait suite, en référence aux figures annexées dans lesquelles :
[Fig. 1] est une vue schématique d'un module selon un premier mode de réalisation de l'invention.
[Fig. 2] est une vue schématique d'un module selon une variante du premier mode de réalisation de l'invention.
[Fig. 3] est une vue schématique d'un module selon un deuxième mode de réalisation de l'invention

Le module selon l'invention comporte des chaines 1, chaque chaine 1 comprenant une ou plusieurs cellules 2 reliées électriquement en série. Les cellules 2 peuvent être mono faciales, ne captant la lumière que par leur face supérieure, ou bifaciales, captant la lumière par leur face supérieure et par leur face inférieure, permettant de capter de la lumière réfléchie après un passage entre les interstices de l'installation.

La surface totale couverte par les cellules 2 d'un module est supérieure ou égale à 1,2 m², de préférence supérieure ou égale à 1,5 m².

Les cellules 2 comportent de préférence du silicium cristallin, cette technologie étant la plus performante pour des coûts acceptables.

Le module comporte une première borne 3a, située sur un premier côté 4a du module, et une deuxième borne 3b, située sur un deuxième côté 4b du module.

Le module comprend un ou plusieurs ensembles aller 5a d'au moins trois chaînes 1 reliées électriquement en parallèle. L'ensemble ou les ensembles aller 5a s'étendent entre la première borne 3a et la deuxième borne 3b.

Le module peut comprendre également un ou plusieurs ensembles retour 5b d'au moins trois chaînes 1 reliées électriquement en parallèle. S'ils sont présents, l'ensemble ou les ensembles retour 5b s'étendent entre la deuxième borne 3b et une troisième borne 3c située sur le premier côté 4a du module.

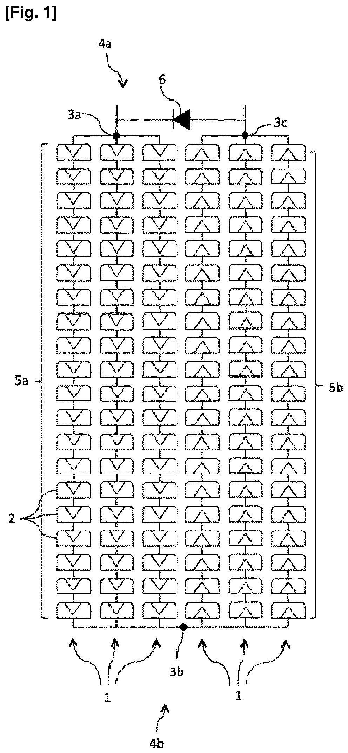

De par cet arrangement des cellules 2 à l'intérieur du module, les caractéristiques électriques du module diffèrent de celles d'un module classique. En effet dans un module classique dont toutes les cellules sont en série, le courant du module est égal au courant d'une cellule. Par exemple, comme représenté en fig. 1, si le module comporte un ensemble aller 5a, un ensemble retour 5b, et que chaque ensemble 5a, 5b comprend trois chaines 1 reliées en parallèles, le courant des trois chaines 1 s'additionne dans les bornes 3a, 3b et 3c du module. Le courant maximal théorique du module selon l'invention est donc trois fois plus important que dans un module classique à une seule chaine. La tension d'une chaine 1 correspond à la somme des tensions de toutes ses cellules 2. En branchant trois chaines 1 identiques en parallèle entre la première borne 3a et la deuxième borne 3b, on obtient une tension égale à la somme des tensions d'une chaine, ce qui représente une tension valant le tiers de celle qu'on obtiendrait en branchant les trois chaines en série.

Dans un mode de réalisation préféré de l'invention, les cellules 2 sont des fractions de cellules de base. On entend par cellule de base une cellule de taille standard, de 156 x 156 mm. Une demi-cellule de base a donc une taille de 156 x 78 mm. Les cellules de base peuvent également être des cellules de taille 125 x 125 mm, 156,75 x 156,75 mm, 157,25 x 157,25 mm, 158,75 x 158, 75 mm, 161,7 x 161,7 mm, 166 x 166 mm, 200 x 200 mm, ou encore 210 x 210 mm, sans sortir du cadre de la présente invention. Les cellules de base sont de forme carrée, ou carrée avec les coins coupés.

Dans un premier mode de réalisation de l'invention, les cellules 2 sont des demi-cellules de base, c'est-à-dire qu'il s'agit de cellules rectangulaires, le cas échéant avec au moins un coin coupé, dont la longueur est égale à deux fois la largeur. Le courant maximal théorique d'une demi-cellule de base est proportionnel à sa surface. Le courant maximal théorique d'une demi-cellule est donc égal à la moitié de celui d'une cellule de base. En ce qui concerne la tension, elle dépend de la nature des couches de matériaux composant la cellule, et reste donc la même, que ce soit aux bornes d'une cellule de base ou d'une demi cellule de base.

Un module selon l'invention dans lequel les cellules 2 sont des demi-cellules de base, comporte deux fois plus de demi cellules 2 qu'un module classique dans lequel les cellules 2 sont des cellules de base, pour une surface donnée, par exemple de 1 m x 1,6 m.

Si on considère qu'une cellule de base produit un courant I₀ avec une tension V₀, un module selon l'état de la technique, avec 60 cellules de base branchées en série avec six chaines de 10 cellules de base, produit un courant I₀ avec une tension de 60 x V₀. Il en est de même avec des modules comportant six chaines de 20 demi cellules de base chacune, les six chaines étant branchées en parallèle deux par deux.

En comparaison, un module de la même taille selon l'invention comportant un ensemble aller 5a et un ensemble retour 5b, chaque ensemble 5a, 5b comprenant trois chaines 1 reliées en parallèles, sera alors constitué de six chaines 1, constituées chacune de 20 demi-cellules de base 2 branchées en série, lesdites chaines 1 étant branchées en parallèle trois par trois. Cette disposition est représentée en fig. 1.

Chacune des chaines 1 produit alors un courant de 0,5 x I₀ avec une tension de 20 x V₀.

Un ensemble de trois chaines en parallèle produit un courant de 1,5 x I₀ avec une tension de 20 x V₀.

Le module produit alors un courant de 1,5 x I₀ avec une tension de 40 x V₀.

Cela représente un courant 1,5 x plus élevé avec une tension 1,5 x plus basse qu'un module de l'état de la technique. On obtient donc la même puissance avec une tension plus faible.

L'usage de demi-cellules permet d'obtenir des caractéristiques globales du module moins éloignées des caractéristiques d'un module classique. Ceci permet une intégration plus facile avec les équipements existants, notamment les onduleurs, les diodes éventuelles, etc... qui ne supportent pas tous des courants très élevés.

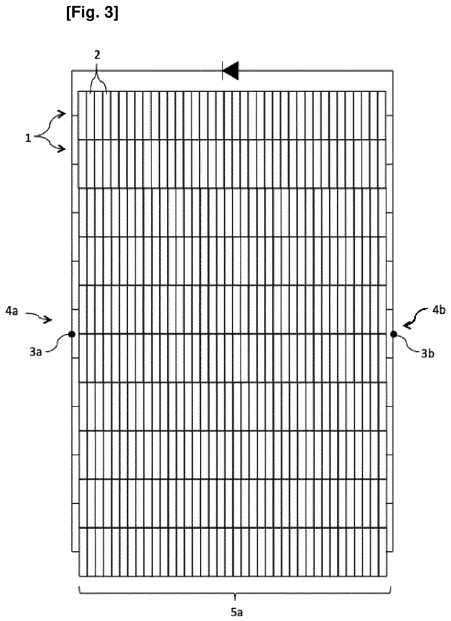

Dans un deuxième mode de réalisation de l'invention, représenté en fig. 3, les cellules 2 sont des sixièmes de cellules de base, c'est-à-dire qu'il s'agit de cellules rectangulaires, le cas échéant avec au moins un coin coupé, dont la longueur est égale à six fois la largeur. Le module comporte alors par exemple dix chaines 1 de 38 cellules en série. Les cellules 2 peuvent être interconnectées par collage, en particulier pour minimiser la distance nécessaire entre deux cellules 2 successives à raccorder.

Chacune des chaines 1 produit alors un courant de 1/6 x I₀ avec une tension de 38 x V₀.

Un ensemble de dix chaines en parallèle produit un courant de 10/6 x I₀ avec une tension de 38 x V₀.

Le module produit alors un courant de 1,67 x I₀ avec une tension de 38 x V₀.

Cela représente un courant 1,67 x plus élevé avec une tension 1,58 x plus basse qu'un module de l'état de la technique. On obtient donc la même puissance avec une tension plus faible.

La baisse de la tension du module permet d'augmenter le nombre de modules branchés en série sur un même onduleur, du fait qu'un tel onduleur présente une capacité limitée en tension. On réduit donc le nombre d'onduleurs pour une puissance donnée, et donc le coût global d'une installation solaire. La longueur de câble nécessaire est également réduite, ce qui simplifie l'installation et permet de réduire les coûts. De plus la réduction de la longueur de câble permet de réduire les pertes par effet Joule, et fait plus que compenser l'augmentation de l'intensité. On peut ainsi améliorer les performances énergétiques globales de l'installation.

Dans une installation solaire, notamment de type photovoltaïque, les modules sont habituellement disposés en plusieurs lignes parallèles entre elles. Les modules sont de préférence orientés vers le soleil, afin de capter le plus d'énergie lumineuse possible au cours de la journée. Dans ces conditions, à certains moments de la journée, les modules forment une zone d'ombre sur les modules situés derrière eux. Cette ombre s'étend sur une partie basse du module, en-dessous d'un certain niveau. Les modules, souvent rectangulaires, sont disposés de manière à ce que leur grand côté soit à l'horizontale, de sorte que la partie basse d'un module corresponde à une chaine de cellules branchées en série entre elles. L'exemple de réalisation représenté en fig. 1 est représenté tourné de 90° par rapport à son implantation préférée, pour des besoins de format de page. Une disposition grand côté à la verticale peut être envisagée aussi dans des situations où l'ombrage serait vertical, sans sortir du cadre de la présente invention.

Dans le cas du module selon l'invention représenté en fig. 1, la zone ombragée correspondrait d'abord à une chaine 1, puis s'étendrait vers le haut, chaine 1 par chaine 1. L'arrangement des cellules 2, représenté dans un mode de réalisation préféré en fig. 1, permet de réduire la sensibilité du module aux problèmes d'ombrage. En effet si une seule chaine est à l'ombre, le courant parcourant les chaines parallèles ne sera pas affecté, et les performances du module seront moins dégradées que si toutes les cellules étaient en série. Par exemple si une des chaines ne produit pas d'énergie et que son courant est nul, le courant total du module ne sera réduit que d'un tiers, alors qu'il serait totalement annulé si toutes les cellules avaient été reliées en série.

Cette réduction de la sensibilité du module aux ombrages permet de disposer les lignes de modules plus proches les unes des autres, et ainsi de disposer plus de modules et de capter plus d'énergie solaire dans un espace donné.

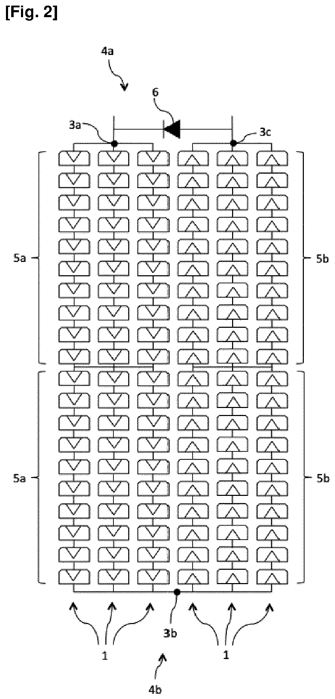

Alternativement à la disposition de la fig. 1, le module selon l'invention peut comporter plusieurs ensembles aller 5a et plusieurs ensembles retour 5b, par exemple deux ensembles aller 5a et deux ensembles retour 5b, comme représenté en fig. 2. La pluralité de sous-ensembles permet de diminuer la longueur des chaînes 1, et ainsi de diminuer encore la sensibilité à l'ombrage du module. En effet, dans la disposition de la fig. 1, l'ombrage d'une partie d'une chaine 1 affecte le courant traversant cette chaine sur toute la longueur. L'énergie captée par les cellules 2 se trouvant au soleil sur l'autre partie de la chaine est alors perdu. Par contre dans la disposition de la fig. 2, si l'ombrage ne touche qu'un sous-ensemble, le courant traversant les cellules de l'autre sous-ensemble n'est pas affecté. La sensibilité à l'ombrage peut ainsi être diminuée en augmentant le nombre de sous-ensemble de chaines. Il n'est toutefois pas rentable d'augmenter ce nombre indéfiniment, car le module s'en trouve complexifié et son coût de fabrication n'est plus rentable par rapport aux gains dus à une moindre sensibilité à l'ombrage.

Le nombre d'ensembles aller 5a est de préférence égal au nombre d'ensembles retour 5b.

Le nombre de cellules par panneau est par exemple supérieur ou égal à 108, de préférence égal à 120.

Les chaines 1 comportent de préférence toutes un nombre identique de cellules 2. En cas d'unique ensemble aller 5a et d'unique ensemble retour 5b, si chaque ensemble comporte trois chaines en parallèle, le nombre de cellules 2 par chaine 1 est par exemple compris entre 18 et 25.

Le module selon l'invention comporte une diode de dérivation 6 connectée électriquement en parallèle avec la totalité des cellules 2 dudit module. Cette diode de dérivation 6 est l'unique diode de dérivation du module. Ceci permet de réduire les coûts de fabrication.

Dans le cas d'un module comportant au moins un ensemble retour 5b, la présence d'une diode de dérivation 6 unique permet de ne pas avoir besoin de disposer un ruban de cuivre entre deux côtés opposés du module. Afin d'installer ce ruban de cuivre, il était possible d'écarter les chaînes aller des chaînes de retour, mais ceci avait pour conséquence une augmentation de la surface du module, donc une diminution de son efficacité surfacique. Alternativement, il était possible d'intercaler un isolant électrique entre le ruban de cuivre et les cellules. Cependant dans le cas d'un module biface, le ruban de cuivre cachait une partie de la face arrière des cellules, diminuant à nouveau l'efficacité surfacique du module. De plus, cette deuxième solution n'était pas envisageable pour les modules dits biverres, dans lesquels les cellules sont disposées entre deux couches de verre, car la contrainte créée par le ruban de cuivre lors du procédé de lamination risquait d'endommager les cellules.

En revanche, le passage à une diode de dérivation 6 unique pose un problème en cas d'ombrage d'une cellule 2. En effet, en cas d'ombrage, même partiel d'une cellule 2 cette dernière se polarise en inverse. Dans le pire des cas, si une cellule 2 unique est ombragée, la tension inverse de cette cellule 2 peut correspondre à la tension totale de la partie du module branchée en parallèle avec une diode de dérivation, moins la tension de la cellule 2 concernée. La puissance électrique à dissiper correspond alors au produit du courant traversant la cellule 2 et de cette tension. Dans le cas du document FR1871040, chaque diode de dérivation est connectée en parallèle avec 20 cellules. La tension maximale en cas d'ombrage d'une des cellules est alors de 19xV₀. Avec V₀ par exemple égal à 0,68V, on a une tension maximale de 12,92V. Mais dans la présente invention, par exemple dans les dispositions des fig. 1 et 2, la diode de dérivation est en parallèle avec 40 cellules 2. La tension maximale en cas d'ombrage d'une des cellules 2 est alors de 39xV₀. Avec V₀ par exemple égal à 0,68V, on a une tension maximale de 26,52V.

Puisque le module ne comporte qu'une diode de dérivation, la valeur de tension maximale est dépendante de la tension totale du module. Le fait que les chaines 1 de cellules 2 soient disposées en parallèle par groupes d'au moins trois permet de réduire cette tension, comme le montrent les calculs plus hauts relatifs aux modes de réalisation des fig. 1 et 3. La disposition en parallèle participe donc à réduire les risques d'endommager les cellules en cas d'ombrage, tout en n'utilisant qu'une diode de dérivation 6 pour l'ensemble du module.

Toutefois afin de limiter un échauffement localisé pouvant endommager la cellule 2 ombragée et/ou les composants qui l'entourent (encapsulant, ruban d'interconnexion...), il est indispensable de limiter la puissance électrique à dissiper. Or cette puissance peut être limitée par la valeur de la tension de claquage des cellules 2. La tension de claquage correspond à la tension dans la région inverse de la cellule photovoltaïque ou le courant commence à augmenter de manière exponentielle. La valeur de la tension de claquage est de la plus haute importante car elle détermine la puissance que la cellule 2 doit dissiper lorsqu'elle est polarisée en inverse.

Afin de réduire les risques de détérioration du module en cas d'ombrage, on utilise de préférence des cellules dont la tension de claquage est supérieure à 25V.

Il s'agit par exemple de cellules 2 fabriquées selon l'une des technologies suivantes : la technologie PERC de type P (P-type Passivated Emitter Rear Contact), la technologie PERT de type N (N-type Passivated Emitter Rear Totally Diffused), la technologie TOPCon (Tunnel Oxide Passivated Contact), et la technologie à hétérojonction HJT (Heterojunction). Ces types de cellules ont une tension de claquage particulièrement élevée, et permettent donc d'obtenir un module selon l'invention avec une diode de dérivation unique, avec des risques réduits de détérioration en cas d'ombrage d'une cellule 2.

Le module selon l'invention peut être fabriqué selon un procédé comportant les étapes suivantes :
- disposition d'une pluralité de cellules 2 selon au moins trois chaines 1,
- connexion desdites cellules 2 en série le long desdites au moins trois chaines 1, pour obtenir un ensemble aller 5a,
- répétition le cas échéant des deux premières étapes pour obtenir une pluralité d'ensembles aller 5a,
- interconnexion en série desdits au moins un ensemble aller entre la première borne 3a et la deuxième borne 3b,
- le cas échéant, répétition des quatre premières étapes pour obtenir un ou plusieurs ensembles retour 5b connectés en série entre la deuxième borne 3b et la troisième borne 3c,
- connexion en parallèle de la diode de dérivation, en parallèle de la totalité des cellules 2 du module.

Bien que la description ci-dessus se base sur des modes de réalisation particuliers, elle n'est nullement limitative de la portée de l'invention, et des modifications peuvent être apportées, notamment par substitution d'équivalents techniques ou par combinaison différente de tout ou partie des caractéristiques développées ci-dessus.

## Revendications

1. Module solaire, notamment de type photovoltaïque, comprenant des chaines (1), chaque chaine (1) comportant une ou plusieurs cellules (2) reliées électriquement en série, la surface totale couverte par les cellules (2) étant supérieure à 1,2 m², **caractérisé en ce que** :
- il comprend plusieurs ensembles aller (5a) d'au moins trois chaines (1) reliées électriquement en parallèle entre elles, lesdits plusieurs ensembles aller (5a) étant reliés électriquement en série entre eux et disposés entre une première borne (3a) sur un premier côté (4a) dudit module et une deuxième borne (3b) située sur un deuxième côté (4b) opposé au premier côté (4a) dudit module,
- ledit module comportant une diode de dérivation (6) connectée électriquement en parallèle avec la totalité des cellules (2) dudit module.

2. Module solaire selon la revendication précédente, dans lequel ladite diode de dérivation (6) est connectée électriquement directement entre la première borne (3a) et la deuxième borne (3b).

3. Module solaire selon la revendication 1, comprenant au moins un ensemble retour (5b) d'au moins trois chaines (1) reliées électriquement en parallèle entre elles, lesdits au moins un ensemble retour (5b) étant reliés électriquement en série entre eux et disposés entre ladite deuxième borne (3b) et une troisième borne (3c) située sur le premier côté (4a) du module, ladite diode de dérivation (6) étant connectée électriquement directement entre la première borne (3a) et ladite troisième borne (3c).

4. Module solaire selon la revendication précédente, comportant au moins deux ensembles aller (5a) et/ou au moins deux ensembles retour (5b).

5. Module solaire selon l'une des revendications précédentes, dans lequel les cellules (2) ont une tension de claquage supérieure ou égale à 25V.

6. Module solaire selon l'une des revendications précédentes, dans lequel les cellules (2) comportent du silicium cristallin.

7. Module solaire selon la revendication précédente, dans lequel la technologie de fabrication desdites cellules (2) est une technologie comprise dans l'ensemble formé par la technologie PERC de type P (P-type Passivated Emitter Rear Contact), la technologie PERT de type N (N-type Passivated Emitter Rear Totally Diffused), la technologie TOPCon (Tunnel Oxide Passivated Contact), et la technologie à hétérojonction HJT (Heterojunction),

8. Module solaire selon l'une des revendications précédentes, dans lequel la longueur desdites cellules (2) est égale à deux fois la largeur desdites cellules (2), ledit module comportant au moins 108 cellules (2), de préférence 120 cellules (2).

9. Module solaire selon l'une des revendications précédentes, dans lequel la longueur desdites cellules (2) est égale à six fois la largeur desdites cellules (2), ledit module comportant au moins 342 cellules (2), de préférence 380 cellules (2).

10. Module solaire biverre selon l'une des revendications précédentes, lesdites cellules (2) étant de préférence bifaciales.
